# EUROPEAN PATENT SPECIFICATION

(11) **EP 0 333 994 B1**
(45) Date of publication and mention of the grant of the patent: **28.09.1994**
(21) Application number: 89101221.3
(22) Date of filing: 25.01.1989
(51) Int. Cl.: B23C 3/12

(54) **A method of chamfering planar plate**
Kantenbearbeitungsmethode für Platten
Méthode de chanfreinage de plaques

(30) Priority: 23.03.1988 JP 68677/88
(43) Date of publication of application: 27.09.1989
(73) Proprietor: Nippon CMK Corp., Iruma-Gun Saitama (JP)
(72) Inventor: Seki, Kameharu, Kawagoe-shi Saitama (JP); Kubo, Isamu, Isesaki-shi Gunma (JP)
(74) Representative: Schickedanz, Willi, Dipl.-Ing.

(56) References cited:
- PATENT ABSTRACTS OF JAPAN vol. 10, no. 37 (M-453)(2094) 14 February 1986,& JP-A-60 191710 (NIHON SHII EMU KEI K.K.) 30 September 1985,
- PATENT ABSTRACTS OF JAPAN vol. 5, no. 29 (M-56)(701) 21 February 1981,& JP-A-55 157417 (TOKYO SHIBAURA DENKI K.K.) 8 December 1980,

## Description

The present invention relates to a method of chamfering edges of planar plate according to the precharacterising portion of claim 1 and 2 respectively and to claim 3; see JP-A-60 191 710. The present invention is developed to chamfer edges of printed wiring board as one of the manufacturing process thereof. However, the method can be utilized as chamfering planar plates in general.

### Description of a Prior Art

Conventional planar plates are conventionally chamfered one by one. Namely, one plate is positioned correctly on a chamfering table and a tool chamfers four edges of the plate, and then the plate is reversed and same process must be repeated.

### Disadvantages of the Prior Art

Such conventional process is time consuming as the plate must be positioned accurately on a table, especially when the chamfering tool is guided automatically. Basically, four edges of the plate are at first chamfered and then the plate must be reversed so that automatic chamfering apparatus is very difficult especially when the plate to be chamfered is thin because positioning of the plate is difficult.

Consequently, conventional chamfering includes disadvantages such that it is difficult to maintain accurate plane. Inaccurate positioning and warping, and/or damage by the tool may frequently occur. Thus, ordinary chamfering is time consuming and results in poor productivity.

### Technical Problem

The object of the present invention is to eliminate or at least mitigate the above mentioned disadvantages and to provide an improved method of chamfering a planar plate so that the chamfering process is performed to a plurality of stacked plates and positioning errors and warp problems are not caused.

### Solution of the Technical Problem

According to the present invention as claimed in claims 1-3, the chamfering method comprises the steps of stacking a plurality of planar plates and of chamfering the border of adjacent plates in stacked plates simultaneously.

Preferably, the chamfering is forming a V-shaped groove of acute angle.

According to another embodiment, the method comprises the steps of stacking a plurality of planar plates, detecting the border between adjacent two plates in the stack, and chamfering the border portion of the plates simultaneously.

### Advantageous Effects of the Invention

As the plates are stacked, positioning of the plates is once for stacked plates and no reverse process is necessary. As the border between the two stacked plates is detected precisely, tool guide is accurately performed and edges to be chamfered is accurately determined. As the tool forms a V-shaped groove, no reverse problem occurs. The method performs accurate chamfering in very short time period although the plates to be chamfered may include thickness variety.

For a conventional chamfering process about 3 - 5 seconds per sheet are necessary, and the chamfer result is not sufficient. Whereas, the present method performs sufficiently accurate chamfering in about 1/3 of the time.

### Brief Description of the Drawings

Figure 1 is a schematic side view, a portion of which broken away, of the chamfering apparatus, according to one embodiment of the present invention.
Figures 2A, 2B and 2C are plan views showing arrangements of stacked plates and working tools, and
Figure 3 is similar to Fig. 2, whereby four tools are provided.

### Detailed Description of the Preferred Embodiments

Now, a preferred embodiment of the present invention as a printed wiring boards chamfering apparatus will be described with reference to the drawings.

The printed wiring boards chamfering apparatus includes a stacking device, an aligning device, a border detecting device, a chamfering device, a turning device and a discharge device.

The stacking device stacks a plurality, e. g. 10 to 250 sheets, of base plates which are cut by a cutting machine in a suitable container of easily disassembled.

At the aligning device, the plates are pushed from both sides to be in parallel with each other, and they are pushed from above so as to maintain stacked state. Then the plates are supplied to the chamfering device.

The border detecting device detects border between adjacent plates by means of CCD camera or proximate sensor detecting copper film which covers the printed wiring board at the chamfering station.

The chamfering device utilizes a numerical control device to move the V-shaped tool to align the tool precisely to the detected border and corrects the copper film thickness of 17 - 35 »m so that the center of the tool precisely aligns with the center of the border. Then the cutter moves along the border, cutting the lower edge of the upper plate and the upper edge of the lower plate by one movement of the cutter.

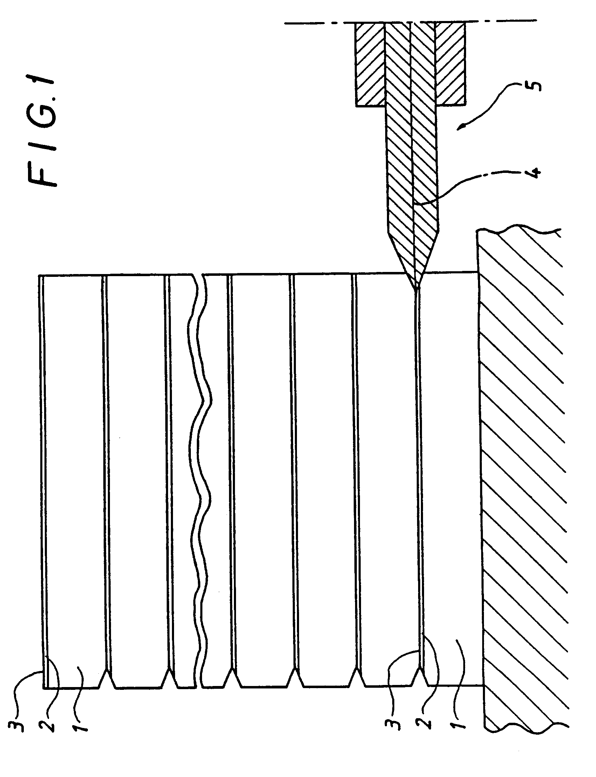

The cutting process is shown in Fig. 1. A copper film 2 on a stacked base plate 1 is detected by a detecting device, not shown, and center line 4 of a tool 5 is aligned with the border line 3 on the copper film 2.

The included angle of the tool may be between 45 - 90° and the tool cut along the border desired depth such as shown in Fig. 1. Cutting is performed sequentially from below. Of course, when both surfaces of the base plate are clad with copper film, the above mentioned correction of copper thickness is not necessary.

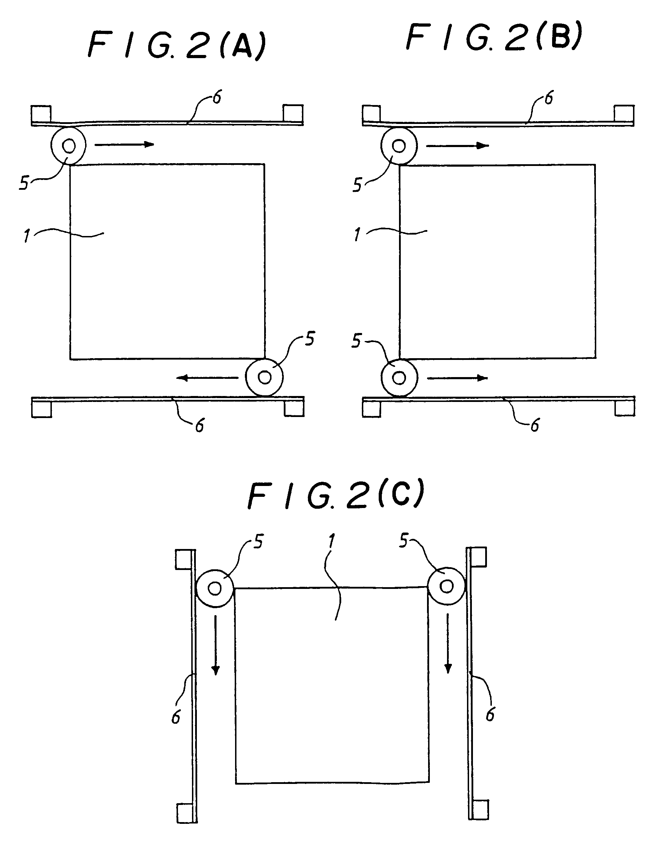

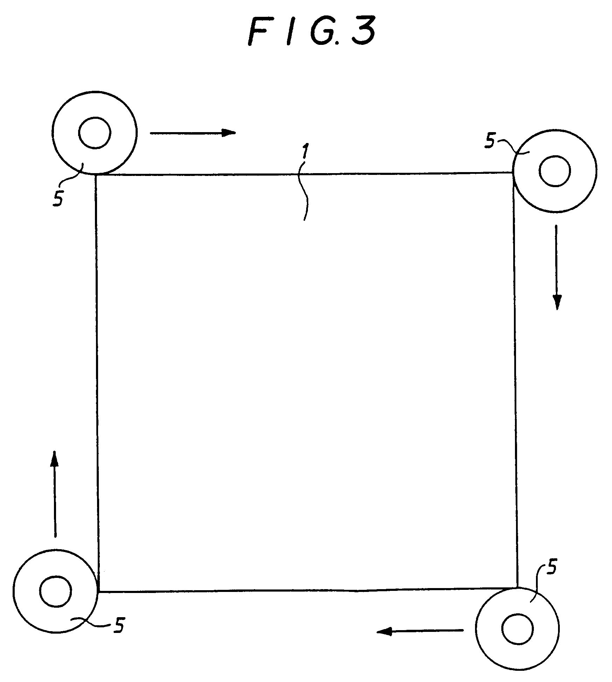

When chamfer cutting reaches to uppermost plate, the turning device turns the stack of plates at 90° to face the tool 5 next surface of the stack of plates 1. As shown in Fig. 2, when two sets of tools are used, one turning is sufficient to chamfer four edges of the plates, and when four sets of tools are utilized as shown in Fig. 3, no turning is necessary to complete chamfer work. In this case, 250 sheets can be chamfered in about 5 minutes. A tool hold and moving device 6 is shown in Fig. 2.

After complete chamfering of eight edges of the plates, the base plates are conveyed to a discharge device where the plates are prepared for a next process not related to the present invention.

In the drawings shown, a rotary cutter is used to perform 45° chamfer. Other desired tool e. g. end mill can be used to perform 90° chamfer. Angle and depth of the chamfer can be selected as desired.

The present invention concerns the chamfering of stacked printed wiring boards as a preferred embodiment. Nonmetallic plates having metal film can be chamfered by utterly the same process. Other plates can be chamfered by utilizing necessary border detect devices having the desired accuracy.

As described, by chamfering the plates in stacked condition, production efficiency is remarkably improved. Flatness of plates is maintained sufficiently, so that warp or incorrect chamfer is not produced.

## Claims

1. A method of chamfering the edges of rectangular plate members, comprising the steps of:
a) stacking a plurality of plate members and
b) chamfering the border portions of adjacent plates simultaneously,
**characterized by** the following steps:
c) chamfering a first side of two adjacent border portions of the face to face stacked plates by means of a chamfering device;
d) turning the stacked plate about 90° and chamfering a second side of the border portions of said stacked plates by means of said chamfering device;
e) further turning the stacked plates about 90° and chamfering a third side of the border portions of said stacked plates by means of said chamfering device;
f) again turning the stacked plates about 90° and chamfering a fourth side of the border portions of said stacked plates by means of said chamfering device.

2. A method of chamfering the edges of rectangular plate members, comprising the steps of:
a) stacking a plurality of plate members and
b) chamfering the border portions of adjacent plates simultaneously,
**characterized by** the following steps:
c) chamfering a first and a second side of two adjacent border portions of the face to face stacked plates by means of two chamfering devices;
d) turning the stacked plates about 90° and chamfering a third and a fourth side of the border portions of the stacked plates by means of said two chamfering devices.

3. A method of chamfering edges of rectangular plates, comprising the following steps:
a) stacking a plurality of plates face to face;
b) aligning said plates;
c) detecting the borders of said plates;
d) chamfering two adjacent edges of said plates.

4. A method according to claims 1 to 3, **characterized in that** the plate members have two pairs of parallel outer sides having upper and lower outer edges, the chamfering steps being carried out simultaneously on two parallel outer sides of the stacked plate members.

5. A method according to claim 4, **characterized in that** the chamfering steps are carried out simultaneously on both pairs of parallel outer sides of the stacked plate members.

6. A method according to claims 1 or 2, **characterized by** the step of detecting the boundary between two adjacent plate members, and carrying out the simultaneously chamfering step in response to detection of the boundary.

7. A method according to claims 1 or 2, **characterized in that** the simultaneously chamfering step comprises displacing a rotating chamfering tool relative to the opposed outer edges of the two adjacent plate members to simultaneously chamfer the opposed outer edges.

8. A method according to claims 1 or 2, **characterized in that** prior to the chamfering a plurality of plate members is provided which are alike in size and which have upper and lower outer peripheral edges to be chamfered, said plate members being stacked in face-to-face vertically aligned relation so that for each two adjacent plate members the upper outer edge of the lower plate member is opposed to the lower outer edge of the upper plate member.

## Patentansprüche

1. Verfahren zum Abschrägen der Kanten von rechteckigen Plattenelementen, mit den Schritten:
a) Stapeln von mehreren Plattenelementen und
b) gleichzeitiges Abschrägen der Randbereiche von benachbarten Platten;
**gekennzeichnet durch** folgende Schritte:
c) Abschrägen einer ersten Seite zweier benachbarter Randbereiche der einander gegenüberliegenden gestapelten Platten mit einer Abschrägvorrichtung;
d) Drehen der gestapelten Platten um 90° und Abschrägen einer zweiten Seite der Randbereiche der besagten gestapelten Platten mit der Abschrägvorrichtung;
e) weiteres Drehen der aufeinanderliegenden Platten um 90° und Abschrägen einer dritten Seite der Randbereiche der besagten gestapelten Platten mit der Abschrägvorrichtung;
f) nochmaliges Drehen der aufeinanderliegenden Platten um 90° und Abschrägen einer vierten Seite der Randbereiche der besagten gestapelten Platten mit der Abschrägvorrichtung.

2. Verfahren zum Abschrägen der Kanten von rechteckigen Plattenelementen, mit den Schritten:
a) Stapeln von mehreren Plattenelementen und
b) gleichzeitiges Abschrägen der Randbereiche von benachbarten Platten;
**gekennzeichnet durch** folgende Schritte:
c) Abschrägen einer ersten und einer zweiten Seite von zwei benachbarten Randbereichen der einander gegenüberliegenden gestapelten Platten mit zwei Abschrägvorrichtungen;
d) Drehen der gestapelten Platten um 90° und Abschrägen einer dritten und einer vierten Seite der Randbereiche der aufeinanderliegenden Platten mit zwei Abschrägvorrichtungen.

3. Verfahren zum Abschrägen der Kanten von rechteckigen Platten, mit den Schritten:
a) Aufeinanderlegen mehrerer Platten Oberfläche auf Oberfläche;
b) Ausrichten der Platten;
c) Erkennen der Ränder der Platten;
d) Abschrägen von zwei benachbarten Kanten der Platten.

4. Verfahren nach den Ansprüchen 1 bis 3, **dadurch gekennzeichnet**, daß die Plattenelemente zwei Paare von parallelen Außenseiten besitzen, welche obere und untere Außenkanten aufweisen, wobei die Abschrägschritte gleichzeitig auf zwei parallelen Außenseiten der gestapelten Plattenelemente ausgeführt werden.

5. Verfahren nach Anspruch 4, **dadurch gekennzeichnet**, daß die Abschrägschritte gleichzeitig an beiden Paaren von parallelen Außenseiten der gestapelten Plattenelemente vorgenommen werden.

6. Verfahren nach den Ansprüchen 1 oder 2, **gekennzeichnet durch** den Schritt des Erkennens der Grenze zwischen zwei benachbarten Plattenelementen und die Ausführung des Schritts des gleichzeitigen Abschrägens in Abhängigkeit von der Erkennung der Grenze.

7. Verfahren nach den Ansprüchen 1 oder 2, **dadurch gekennzeichnet**, daß der Schritt des gleichzeitigen Abschrägens das Verschieben eines sich drehenden Abschrägwerkzeugs relativ zu den sich gegenüberliegenden Außenkanten von den zwei benachbarten Plattenelementen umfaßt, um die sich gegenüberliegenden Außenkanten gleichzeitig abzuschrägen.

8. Verfahren nach den Ansprüchen 1 oder 2, **dadurch gekennzeichnet**, daß vor dem Abschrägen mehrere Plattenelemente bereitgestellt werden, die sich in der Größe entsprechen und die obere und untere abzuschrägende äußere Umfangskanten aufweisen, wobei die Plattenelemente Oberfläche auf Oberfläche in vertikal ausgerichteter Beziehung zueinander gestapelt werden, so daß bei jeweils zwei benachbarten Plattenelementen die obere Außenkante des unteren Plattenelements der unteren Außenkante des oberen Plattenelements gegenüberliegt.

## Revendications

1. Procédé pour chanfreiner des bords d'éléments en forme de plaques rectangulaires, comprenant les étapes consistant à :
a) empiler plusieurs éléments en forme de plaques; et
b) chanfreiner simultanément les portions limites de plaques adjacentes,
caractérisé par les étapes ci-après :
c) chanfreiner, au moyen d'un dispositif de chanfreinage, un premier côté de deux portions limites adjacentes des plaques empilées face contre face;
d) soumettre les plaques empilées à une rotation de 90° et chanfreiner, au moyen dudit dispositif de chanfreinage, un deuxième côté des portions limites desdites plaques empilées;
e) soumettre les plaques empilées à une rotation ultérieure de 90° et chanfreiner, au moyen dudit dispositif de chanfreinage, un troisième côté des portions limites desdites plaques empilées;
f) soumettre une nouvelle fois les plaques empilées à une rotation de 90° et chanfreiner, au moyen dudit dispositif de chanfreinage, un quatrième côté des portions limites desdites plaques empilées.

2. Procédé pour chanfreiner des bords d'éléments en forme de plaques rectangulaires, comprenant les étapes consistant à :
a) empiler plusieurs éléments en forme de plaques; et
b) chanfreiner simultanément les portions limites de plaques adjacentes,
caractérisé par les étapes ci-après :
c) chanfreiner, au moyen de deux dispositifs de chanfreinage, un premier et un deuxième côté de deux portions limites adjacentes des plaques empilées face contre face;
d) soumettre les plaques empilées à une rotation de 90° et chanfreiner, au moyen desdits deux dispositifs de chanfreinage, un troisième et un quatrième côté des portions limites des plaques empilées.

3. Procédé pour chanfreiner des bords de plaques rectangulaires, comprenant les étapes ci-après :
a) empiler plusieurs plaques face contre face;
b) aligner lesdites plaques;
c) détecter les limites desdites plaques;
d) chanfreiner deux bords adjacents desdites plaques.

4. Procédé selon les revendications 1 à 3, caractérisé en ce que les éléments en forme de plaques possèdent deux paires de côtés externes parallèles comportant des bords externes supérieurs et inférieurs, les étapes de chanfreinage étant effectuées de manière simultanée sur deux côtés externes parallèles des éléments en forme de plaques empilées.

5. Procédé selon la revendication 4, caractérisé en ce qu'on effectue les étapes de chanfreinage simultanément sur les deux paires de côtés externes parallèles des éléments en forme de plaques empilés.

6. Procédé selon la revendication 1 ou 2, caractérisé par l'étape consistant à détecter la limite entre deux éléments adjacents en forme de plaques et à effectuer simultanément l'étape de chanfreinage en réponse à la détection de la limite.

7. Procédé selon la revendication 1 ou 2, caractérisé en ce que l'étape de chanfreinage simultané comprend le fait de déplacer un outil rotatif de chanfreinage par rapport aux bords externes opposés de deux éléments adjacents en forme de plaques pour chanfreiner simultanément les bords externes opposés.

8. Procédé selon la revendication 1 ou 2, caractérisé en ce que, avant le chanfreinage, on procure plusieurs éléments en forme de plaques qui sont de même dimension et qui possèdent des bords périphériques externes supérieurs et inférieurs qui doivent être chanfreinés, lesdits éléments en forme de plaques étant empilés face contre face dans une relation d'alignement vertical de telle sorte que, chaque fois pour deux éléments adjacents en forme de plaques, le bord externe supérieur de l'élément inférieur en forme de plaque est opposé au bord externe inférieur de l'élément supérieur en forme de plaque.
